Europäisches Patentamt

European Patent Office

Office européen des brevets

(19)

(11) EP 1 284 530 A2

(12) **EUROPEAN PATENT APPLICATION**

(43) Date of publication:
**19.02.2003 Bulletin 2003/08**

(51) Int Cl.⁷: **H01S 5/022**

(21) Application number: **02014002.6**

(22) Date of filing: **26.06.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **26.06.2001 JP 2001192383**

(71) Applicant: **The Furukawa Electric Co., Ltd.
Tokyo 100-8322 (JP)**

(72) Inventors:
• **Nasu, Hideyuki**
  **Chiyoda-ku, Tokyo 100-8322 (JP)**
• **Nomura, Takehiko**
  **Chiyoda-ku, Tokyo 100-8322 (JP)**

(74) Representative: **Zimmermann, Gerd Heinrich et al
Zimmermann & Partner,
Postfach 33 09 20
80069 München (DE)**

(54) **Optical module**

(57)   An optical module includes a light-emitting device1 that outputs light, a sub-mount 2 made of a dielectric substance having thermal conductivity on which the light-emitting device is placed, a base made 3 of a metal on which the sub-mount is placed, a cooling device 4 on which the base is placed and which cools heat generated by the light-emitting device, and a power supply line 5 that is provided on the sub-mount and supplies the light-emitting device with a high-frequency modulating signal for driving the light-emitting device 1, where capacitances Cs and Cp of the sub-mount and the cooling device are connected in series to an equivalent circuit formed between the light-emitting device and the ground.

Fig.1

EP 1 284 530 A2

**Description**

The present invention relates to an optical module placed in an optical transmitter used in an optical communication system.

There have conventionally been developed optical modules that are each capable of modulating output light by inputting a high-frequency modulating signal into a light-emitting device or a light modulating device.

The present invention intends to overcome the above problems. The object is solved by the optical module according to independent claims 1 and 6.

Further advantages, features, aspects and details of the invention are evident from the dependent claims, the description and the accompanying drawings.

The present invention generally relates to optical modules. In particular, it relates to optical modules for high-frequency modulation. More specifically, the present invention also relates to an optical module placed in an optical transmitter used in an optical communication system.

An optical module according to the embodiment of the present invention includes a light-emitting device that outputs light, a sub-mount made of a dielectric substance having thermal conductivity on which the light-emitting device is placed, a base made of a metal on which the sub-mount is placed, a cooling device on which the base is placed and which cools heat generated by the light-emitting device, and a power supply line that is provided on the sub-mount and supplies the light-emitting device with a high-frequency modulating signal for driving the light-emitting device, where capacitances Cs and Cp of the sub-mount and the cooling device are connected in series to an equivalent circuit formed between the light-emitting device and the ground

An optical module according to the embodiment of the present invention also includes a light modulating device that modulates light; a sub-mount made of a dielectric substance having thermal conductivity on which said light modulating device is placed; a base made of a metal on which said sub-mount is placed; a cooling device on which said base is placed and which cools heat generated by said light-emitting device; and a power supply line that is provided on said sub-mount and supplies said light-emitting device with a high-frequency modulating signal for driving said light modulating device, wherein capacitances of said sub-mount and said cooling device are connected in series to an equivalent circuit formed between said light modulating device and a ground.

The invention will be better understood by reference to the following description of embodiments of the invention taken in conjunction with the accompanying drawings, wherein

Fig. 1 is a front view showing an optical module according to a first embodiment of the present invention;

Fig. 2A is a top view showing a power supply line and Fig. 2B is a top view showing a modification of the power supply line;

Fig. 3 shows an equivalent circuit in a case where a high-frequency modulating signal is inputted into the optical module according to the first embodiment of the present invention;

Fig 4 (A) is a graph showing the variety of the value of Ca/Cp for Cs/CP, and Fig. 4 (B) is a graph showing a high-frequency response characteristic of the optical module according to the first embodiment of the present invention;

Fig. 5A is a top view showing an LD sub-mount of an optical module according to a second embodiment of the present invention and Fig. 5B is a cross-sectional view taken along the line b-b in Fig. 5A;

Fig. 6 is a side view showing an overall construction of the optical module according to the embodiment of the present invention;

Fig. 7 is a top view showing the overall construction of the optical module according to the embodiment of the present invention;

Fig. 8 is a front view illustrating an example of a conventional optical module;

Fig. 9 shows an equivalent circuit in a case where a high-frequency modulating signal is inputted into the conventional optical module shown in Fig. 8;

Fig. 10 is a graph showing a high-frequency response characteristic of the conventional optical module shown in Fig. 8;

Fig. 11 is a top view showing a power supply line according to a third embodiment of the present invention; and

Fig. 12 shows an equivalent circuit in the case where a high-frequency modulating signal is inputted into an optical module according to the third embodiment of the present invention.

Embodiments of the present invention will be described below by comparing them with a conventional technique.

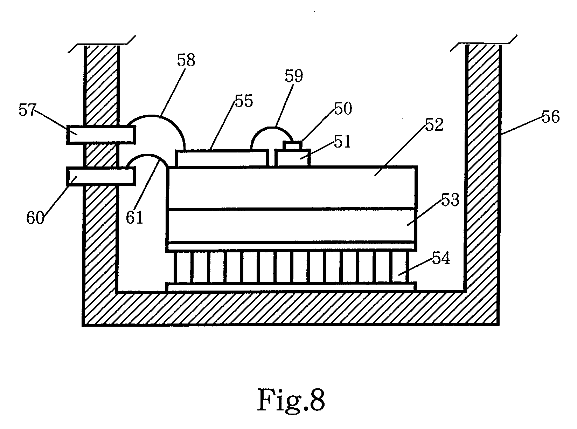

Fig. 8 is a front view illustrating an example of a conventional optical module. As shown in Fig. 8, the conventional optical module includes a light-emitting device 50, such as a semiconductor laser diode, that outputs laser light, a heat sink 51 on which the light-emitting device 50 is placed and fixed, an LD sub-mount 52 on which the heat sink 51 is placed and fixed, a base 53 on which the LD sub-mount 52 is placed and fixed, a cooling device 54, such as a Peltier module, on which the base 53 is placed and fixed and which cools heat generated by the light-emitting device 50, a micro-strip line 55 that inputs a high-frequency modulating signal into the light-emitting device 50, and a package 56 that hermetically seals the inside.

The heat sink 51 is made of a material having high thermal conductivity such as aluminum nitride or diamond. The LD sub-mount 52 is made of a metal having high thermal conductivity such as a copper-tungsten alloy. The base 53 is made of a metal having high thermal conductivity such as a copper-tungsten alloy.

The micro-strip line 55 has been designed to have a specific impedance in order to input a high-frequency modulating signal. Also, a first bonding wire 58 is stretched between a signal inputting portion 57 of the package 56 and the micro-strip line 55 in order to input the high-frequency modulating signal into the micro-strip line 55. Further, a second bonding wire 59 is stretched between the micro-strip line 55 and the light-emitting device 50 in order to input the high-frequency modulating signal into the light-emitting device 50.

The heat sink 51, the LD sub-mount 52, and the base 53 are electrically at the same potential and the underside of the micro-strip line 55 is also at the same potential. Also, a third bonding wire 61 is stretched between the LD sub-mount 52 or the base 53 and a ground portion 60 of the package 56, thereby realizing the same potential.

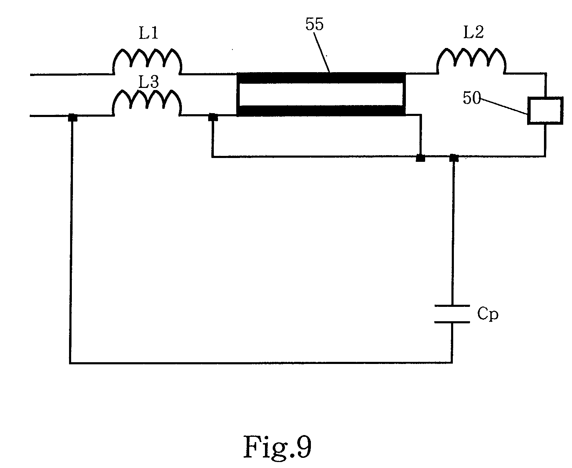

Fig. 9 shows an equivalent circuit in the case where a high-frequency modulating signal is inputted into the light-emitting device 50 of the conventional optical module shown in Fig. 8. In the case of a high-frequency circuit, as shown in Fig. 9, the wires, the cooling device, and the like have parasitic inductances L1, L2, and L3, and capacitance Cp. In Fig. 9, L1 indicates an inductance of the first bonding wire 58; L2, an inductance of the second bonding wire 59; L3, an inductance of the third bonding wire 61; and Cp, a capacitance of the cooling device 54.

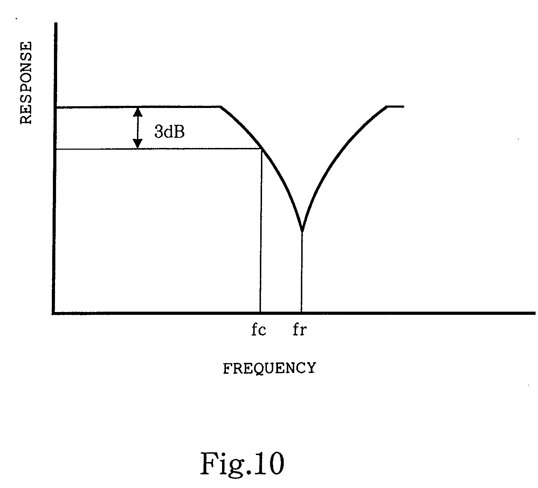

Fig. 10 is a graph showing a high-frequency response characteristic of the conventional optical module shown in Fig. 8. In Fig. 10, a usable frequency band is usually defined so as to remain below a cut-off frequency fc at which there occurs degradation of 3 dB. Consequently, the usable frequency band is in a range of from 0 to fc.

Also, as shown in Fig. 9, the inductance L3 of the third bonding wire 61 and the capacitance Cp of the cooling device 54 are arranged in parallel on a circuit, so that a resonance frequency fr is expressed by the following equation.

$$fr = \frac{1}{2\pi\sqrt{L3 \cdot Cp}}$$

As shown in Fig. 10, the response characteristic sharply drops at this resonance frequency fr, which imposes a limitation on the usable frequency band. As described above, in the conventional optical module, the resonance frequency fr is determined by L3 and Cp. Consequently, the usable frequency band becomes around 2 GHz and it has been impossible to further widen the usable frequency band.

In each embodiment of the present invention, there is provided an optical module that makes it possible to widen the usable frequency band and to input a high-frequency modulating signal into a light-emitting device or a light modulating device.

First Embodiment

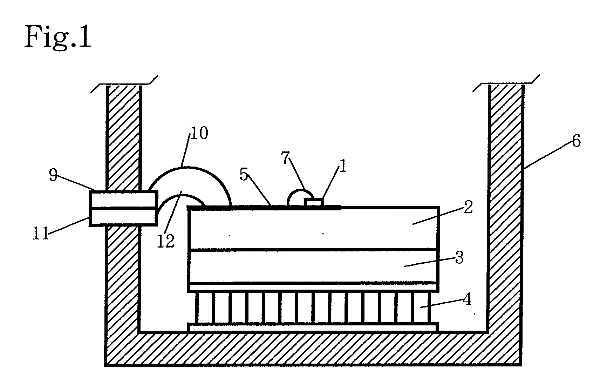

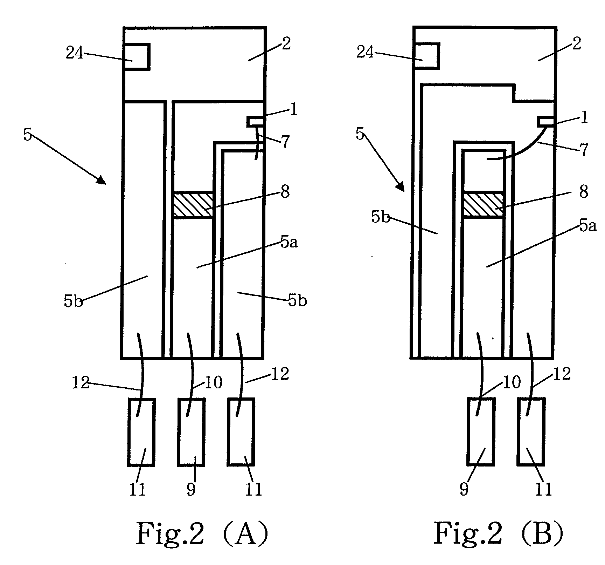

Fig. 1 is a front view showing an optical module according to the first embodiment of the present invention, while Fig. 2A is a top view showing a power supply line.

As shown in Fig. 1, the optical module according to the first embodiment of the present invention includes a light-emitting device 1, such as a semiconductor laser diode, that outputs laser light, an LD sub-mount 2 on which the light-emitting device 1 is placed, a base 3 on which the LD sub-mount 2 is placed and fixed, a cooling device 4, such as a Peltier module, on which the base 3 is placed and fixed and which cools heat generated by the light-emitting device 1, a power supply line 5 that is provided on the LD sub-mount 2 and supplies the light-emitting device 1 with a high-frequency modulating signal for driving the light-emitting device 1, and a package 6 that hermetically seals the inside.

It is required that the LD sub-mount 2 has a capacitance, so that there is used a dielectric substance. It is also required that the LD sub-mount 2 has high thermal conductivity. Consequently, in this embodiment, there is, for instance, used a ceramic dielectric substance such as AlN, SiC, Si, and Polyimide. The base 3 is made of a metal having high thermal conductivity such as a copper-tungsten alloy.

It is preferable that the power supply line 5 is a transmission line that strongly confines a high-frequency signal, is capable of suppressing wavelength chirp due to the intrusion of a leaked electric field, and is capable of responding at high speed. In this embodiment, there is used a coplanar line that forms an electric field between a signal line 5a and a ground line 5b and confines a high-frequency modulating signal.

As shown in Fig. 2A, the signal line 5a and the ground line 5b are formed side by side and the surfaces thereof are metallized with an Au film or the like. The signal line 5a is formed to have a nearly L-letter shape as viewed in a top view and the light-emitting device 1 is directly attached to a tip portion of the signal line 5a. A lower electrode of the light-emitting device 1 and the signal line 5a are electrically connected to each other. An upper electrode of the light-emitting device 1 is electrically connected to the ground line 5b by a second bonding wire 7.

Also, for the signal line 5a of the power supply line 5, there is formed a thin-film resistor 8 made of Ta2N for the sake of impedance adjustment, for instance.

Also, a first bonding wire 10 is stretched between a signal inputting portion 9 of the package 6 and the signal line 5a of the power supply line 5 in order to input a high-frequency modulating signal'into the signal line 5a. Further, a third bonding wire 12 is stretched between a ground portion 11 of the package 6 and the ground line 5b of the power supply line 5.

The package 6 is made of kovar, a copper-tungsten alloy, or the like, for instance.

It should be noted here that as shown in Fig. 2B, a construction, in which the light-emitting device 1 is fixed on the ground line 5b, may be used as a coplanar construction. In this modification, the lower electrode of the light-emitting device 1 is electrically connected to the ground line 5b and the upper electrode of the light-emitting device 1 is electrically connected to the signal line 5a by the second bonding wire 7.

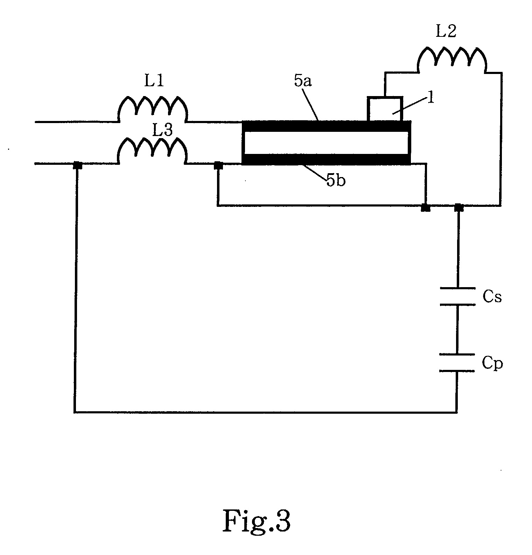

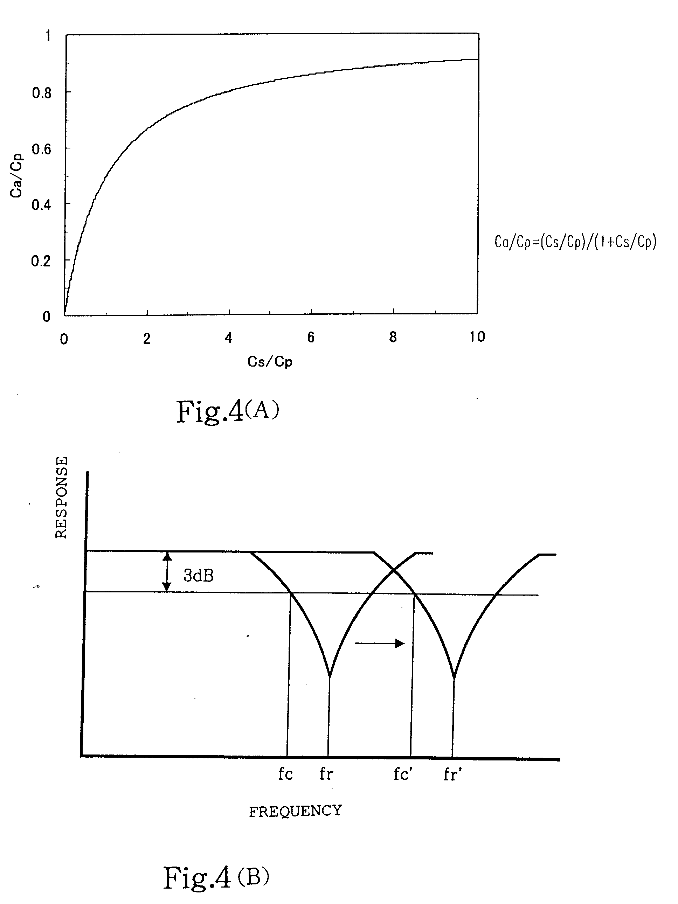

Fig. 3 shows an equivalent circuit in the case where a high-frequency modulating signal is inputted into the optical module according to the first embodiment of the present invention. Fig 4 (A) is a graph showing the variety of the value of Ca/Cp for Cs/CP, and Fig. 4 (B) is a graph showing a high-frequency response characteristic of the optical module according to the first embodiment of the present invention.

In Fig. 3, L1 indicates an inductance of the first bonding wire 10; L2, an inductance of the second bonding wire 7; L3, an inductance of the third bonding wire 12; Cs, a capacitance of the LD sub-mount 2; and Cp, a capacitance of the cooling device 4.

As shown in Fig. 3, the capacitance Cs of the LD sub-mount 2 and the capacitance Cp of the cooling device 4 are connected in series to the equivalent circuit formed between the light-emitting device 1 and the ground.

Accordingly, a synthetic capacitance Ca of Cs and Cp has the following relation.

$$1/Ca=1/CP+1/Cs$$

Consequently, the synthetic capacitance Ca becomes Ca=(Cp×Cs)/(Cp+Cs).

The value of Ca/Cp for Cs/CP obtained by normalizing the capacitance Cs of the LD sub-mount and the synthetic capacitance Ca with respect to the capacitance Cp of the cooling device varies according to the aforementioned formula as shown in Fig. 4(A). By connecting the capacitance Cs of the LD sub-mount in series with Cp in the above manner, the synthetic capacitance Ca can be reduced. In order to effectively reduce Ca, it is desirable that Cs 2Cp.

If Cp=2pF and Cs=1pF, for instance, Ca becomes 0.67pF that is smaller than Cp. From Equation (1) described above, the resonance frequency is inversely proportional to the 1/2nd power of the capacitance. Accordingly, as shown in Fig. 4, the resonance frequency fr' in this embodiment becomes higher than fr in the conventional case. Accordingly, the cut-off frequency fc' in this embodiment becomes higher than fc in the conventional case. As a result, it becomes possible to widen the usable frequency band to a range of from 0 to fc'.

For instance, in the case where, as the optical module of this embodiment, there are used the LD sub-mount 2 made of AlN having a width of around 1.8 mm, a depth of around 6.9 mm, and a height of around 8.3 mm, a Peltier module (KSML01023Z) manufactured by Komatsu Electronics Inc., and the first to third bonding wires 7, 10, and 12 having a diameter of 0.25 mm and a length of 0.7 mm or shorter, it becomes possible to widen the usable frequency band to 3.5 GHz.

Second Embodiment

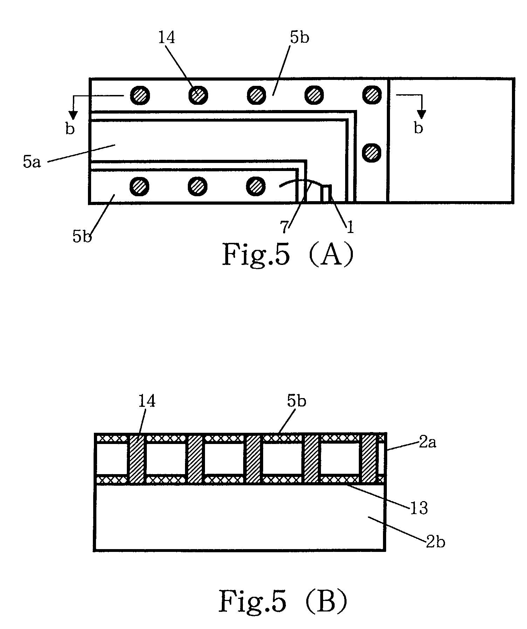

Fig. 5A is a top view showing an LD sub-mount 2 of an optical module according to the second embodiment of the' present invention, while Fig. 5B is a cross-sectional view taken along the line b-b in Fig. 5A.

In the first embodiment, a coplanar transmission line is formed to allow the LD sub-mount 2 to have a capacitance. However, in the case where the frequency of a high-frequency modulating signal transmitted to the signal line 5a is high, there may occur a potential disturbance when a distance from the ground portion 11 of the package 6 is increased.

In view of this problem, in the second embodiment, as shown in Figs. 5A and 5B, the LD sub-mount 2 is constructed from a first layer 2a and a second layer 2b that are separated from each other, with a metallic film 13, such as an Au film, being sandwiched therebetween. Via holes 14 (connecting portions) made of titanium or the like are formed between the ground line 5b on the upper surface of the first layer 2a and the metallic film 13. As a result, there is obtained a transmission line pattern having a grounded coplanar construction.

With the technique of the second embodiment, the metallic film 13 is connected to the ground, so that the dielectric substance of the second layer 2b existing below the metallic film 13 becomes a capacitance of the LD sub-mount 2 connected to the capacitance of the cooling device 4 in series. As a result, it becomes possible to prevent the potential disturbance.

When the LD sub-mount is configured in such a manner, the capacitance Cs of the LD sub-mount can have a predetermined value regardless of the design in the ground line 5b. The resonance frequency in the equivalent circuit shown in Fig. 3 can freely be designed.

It should be noted here that the LD sub-mount 2 may be constructed using at least three layers where metallic layers are sandwiched therebetween and each layer may be provided with via holes that electrically connect the ground line 5b on the top layer to the metallic film on a layer lower than the top layer.

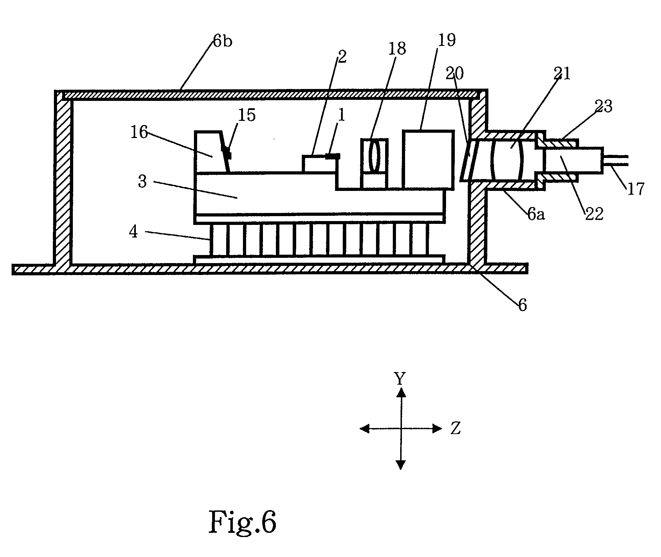

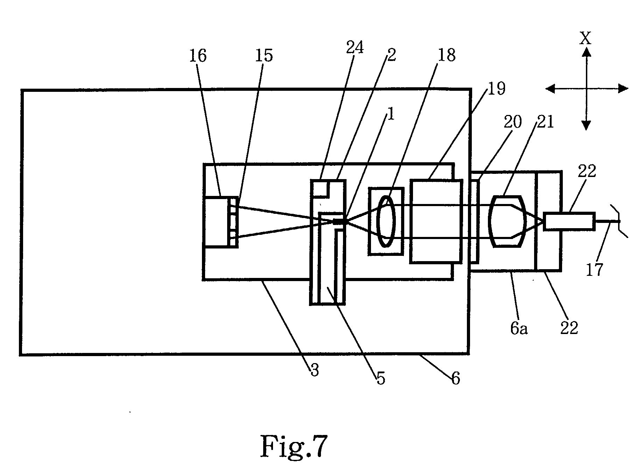

Fig. 6 is a side view showing the overall construction of the optical module according to this embodiment of the present invention, while Fig. 7 is a top view showing the overall construction of the optical module according to this embodiment of the present invention.

As shown in Figs. 6 and 7, the optical module according to this embodiment of the present invention includes a light-receiving device 15, such as a photodiode, that receives laser light for monitoring outputted from a back facet (on the left side in Fig. 6) of the light-emitting device 1 among laser light outputted from the light-emitting device 1, a PD sub-mount 16 on which the light-receiving device 15 is placed, and an optical fiber 17 that receives incident laser light outputted from a front facet (on the right side in Fig. 6) of the light-emitting device 1 and sends the laser light to the outside.

On the front side (right side in Fig. 6) of the light-emitting device 1, there is provided a parallel lens 18 that converts the laser light outputted from the front facet into parallel light. Also, on the front side of the parallel lens 18, there is provided an optical isolator 19 that cuts off light returning to the light-emitting device 1. This optical isolator 19 is a well-known optical isolator that is constructed, for instance, by combining a polarizer with a Faraday rotator.

Within a flange portion 6a formed in a side portion of the package 6, there are provided a window portion 20 on which laser light passing through the optical isolator 19 is incident, and a condensing lens 21 that condenses laser light.

The tip portion of the optical fiber 17 is held by a ferrule 22 made of a metal and this ferrule 22 is fixed by YAG laser welding within a slide ring 23 fixed to an end portion of the flange portion 6a.

An LD sub-mount 2, the PD sub-mount 16, the parallel lens 18, and the optical isolator 19 are fixed on a base 3. The base 3 is fixed on a cooling device 4 constructed from a Peltier module to cool heat generated by the light-emitting device 1.

Also, on the LD sub-mount 2, there is provided a thermistor 24 that detects the temperature of the light-emitting device 1, and the cooling device 4 is controlled so that the temperature detected by the thermistor 24 is kept constant.

A lid 6b is put on the upper portion of the package 6 and the edge portion of the lid 6b is subjected to resistance seam welding for fixation to the package 6 (see Fig. 6).

The laser light outputted from the front facet of the light-emitting device 1 is converted into parallel light by the parallel lens 18, is condensed by the condensing lens 21 through the optical isolator 19 and the window portion 20, is incident on the optical fiber 17, and is sent to the outside.

On the other hand, the laser light outputted from the back facet of the light-emitting device 1 is received and monitored by the light-receiving device 15. On the basis of a monitoring result by the light-receiving device 15, the amount of a driving current to the light-emitting device 1 is adjusted by an APC circuit or the like, so that a light output is controlled and kept constant.

Note that various kinds of optical components, such as a lens, a half mirror, and an optical filter may be provided on an optical path between the light-emitting device 1 and the light-receiving device 15. For instance, there may be used a wavelength monitoring portion that monitors the wavelength of light outputted from the back facet of the light-emitting device 1.

Third Embodiment

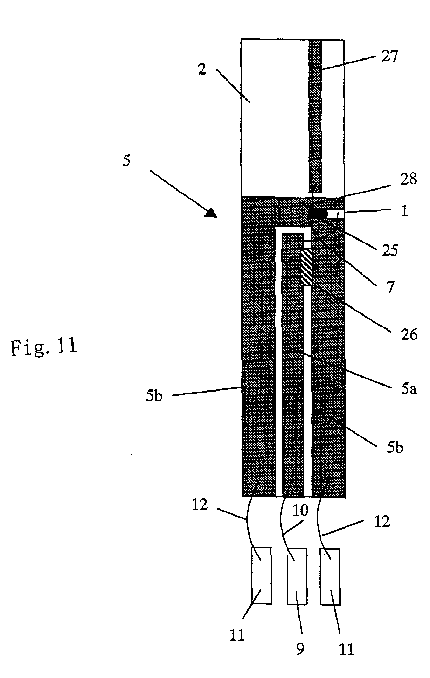

Fig. 11 is a top view showing a power supply line according to the third embodiment of the present invention.

An optical module according to the third embodiment of the present invention includes a semiconductor integrated device in which a light-emitting device 1, such as a semiconductor laser diode, that outputs laser light is integrated with an electro-absorption modulator (hereinafter referred to as the "EA modulator"). Other constructions are the same as those of the optical module in the first embodiment.

This embodiment will be described with reference to Fig. 11. In this embodiment, a high-frequency modulating signal is inputted into the EA modulator. A power supply line 5 includes a signal line 5a, a ground line 5b, and a bias line 27. The light-emitting device 1 and the EA modulator 25 are placed on the ground line 5b and are electrically connected. An upper electrode of the EA modulator 25 is electrically connected to the signal line 5a by a second bonding wire and a parallel thin-film resistor 26 is formed between the signal line 5a and the ground line 5b so as to become a parallel resistance with the EA modulator 25 on the circuit.

A first bonding wire 10 is stretched between a signal inputting portion 9 of a package 6 and the signal line 5a of the power supply line 5 in order to input a high-frequency modulating signal into the signal line 5a. Also, a third bonding wire 12 is stretched between each ground portion 11 of the package 6 and the ground line 5b of the power supply line 5.

Also, the power supply line 5 includes the bias line 27 and an upper electrode of the light-emitting device 1 is electrically connected to the bias line 27 by a fourth bonding wire.

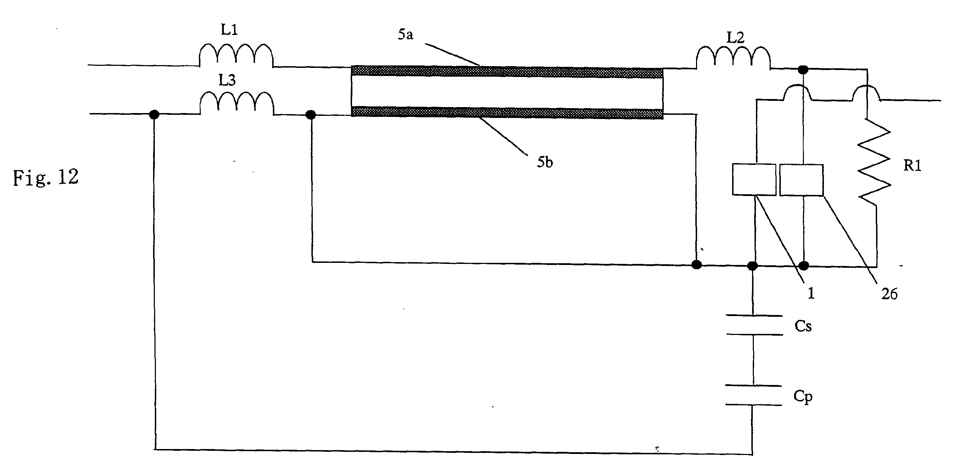

Fig. 12 shows an equivalent circuit in the case where a high-frequency modulating signal is inputted into an optical module according to the third embodiment.

In Fig. 12, L1 indicates an inductance of the first bonding wire 10; L2, an inductance of the second bonding wire 7; L3 an inductance of the third bonding wire 12; R1 a resistance of the parallel thin-film resistor 26; Cs, a capacitance of the LD sub-mount 2; and Cp, a capacitance of the cooling device 4.

Even in the case where light modulation is performed using a light modulator having this construction, it is possible to widen a frequency band like in the first embodiment.

It should be noted here that in this embodiment, there is used a semiconductor integrated device in which a light-emitting device is integrated with an EA modulator. However, even in the case where there is used a device that is not integrated with a light-emitting device and has only a light modulating function, it is possible to obtain the same effect.

The present invention is not limited to the embodiments described above and it is possible to make various modifications without departing from technical scopes described in the following claims.

## Claims

1. An optical module comprising:

   a light-emitting device (1) that outputs light;
   a sub-mount (2) made of a dielectric substance having thermal conductivity on which said light-emitting device is placed;
   a base (3) made of a metal on which said sub-mount is placed;
   a cooling device (4) on which said base is placed and which cools heat generated by said light-emitting device; and
   a power supply line (5) that is provided on said sub-mount and supplies said light-emitting device with a high frequency modulating signal for driving said light-emitting device,

   wherein capacitances of said sub-mount and said cooling device are connected in series to an equivalent circuit formed between said light-emitting device and a ground.

2. The optical module according to claim 1,
   wherein said power supply line is a coplanar line having a signal line (5a) for transmitting a high-frequency signal and a ground line (5b) connected to the ground.

3. The optical module according to claim 2,
   wherein one electrode of said light-emitting device is directly attached and electrically connected to the signal line, and
   the other electrode of said light-emitting device is electrically connected to the ground line through a wire (7).

4. The optical module according to claim 2,
   wherein one electrode of said light-emitting device is directly attached and electrically connected to the ground line, and
   the other electrode of said light-emitting device is electrically connected to the power supply line through a wire (7).

5. The optical module according to any of claims 2 to 4,
   wherein said sub-mount is constructed from a plurality of layers where a metallic film (13) is sandwiched therebetween and each layer is provided with a connecting portion that electrically connects the ground line on a top layer and the metallic film lower than the top layer.

6. An optical module comprising;

   a light modulating device that modulates light;
   a sub-mount (2) made of a dielectric substance having thermal conductivity on which said light modulating device is placed;
   a base (3) made of a metal on which said sub-mount is placed;
   a cooling device (4) on which said base is placed and which cools heat generated by said light-emitting device; and
   a power supply line (5) that is provided on said sub-mount and supplies said light-emitting device with a high-frequency modulating signal for driving said light modulating device,

   wherein capacitances of said sub-mount and said cooling device are connected in series to an equivalent circuit formed between said light modulating device and a ground.

7. The optical module according to claim 6,
   wherein said power supply line is a coplanar line having a signal line (5a) for transmitting a high-frequency signal and a ground line (5b) connected to said ground.

8. The optical module according to claim 7,
   wherein one electrode of said light modulating device is directly attached and electrically connected to said signal line, and the other electrode of said light modulating device is electrically connected to the ground line through a wire (7).

9. The optical module according to claim 7,
   wherein one electrode of said light modulating device is directly attached and electrically connected to the ground line, and the other electrode of said light modulating device is electrically connected to the power supply line through a wire (7).

10. The optical module according to any of claims 7 to 9,
    wherein said sub-mount is constructed from a plurality of layers where a metallic film (13) is sandwiched therebetween, and each layer is provided with a connecting portion that electrically connects the ground line on a top layer and the metallic film on a layer lower than the top layer.

11. The optical module according to any of claims 6 to 10,
    wherein said light modulating device is a semiconductor integrated device in which the light-emitting device (1) and said light modulating device are integrated with each other.

Fig.1

Fig.2 (A)          Fig.2 (B)

Fig.3

$$Ca/Cp=(Cs/Cp)/(1+Cs/Cp)$$

## Fig.4(A)

## Fig.4(B)

Fig.5 (A)

Fig.5 (B)

Fig.6

Fig.7

Fig.8

Fig.9

Fig.10

Fig. 11

Fig. 12